# EUROPEAN PATENT APPLICATION

(11) **EP 2 434 838 A1**
(43) Date of publication of application: **28.03.2012**
(21) Application number: 10793751.8
(22) Date of filing: 26.03.2010
(51) Int. Cl.: H05B 33/04, H01L 51/50, H05B 33/10

(54) **ORGANIC EL DISPLAY DEVICE AND METHOD FOR MANUFACTURING SAME**

(30) Priority: 29.06.2009 JP 2009153657
(71) Applicant: Sharp Kabushiki Kaisha, Osaka-shi, Osaka 545-8522 (JP)
(72) Inventor: Takeshi Hirase, Osaka 545-8522 (JP); Yuhki Kobayashi, Osaka 545-8522 (JP)
(74) Representative: Müller-Boré & Partner Patentanwälte
(86) International application number: PCT/JP2010/002224
(87) International publication number: WO 2011/001573

(57) **Abstract**

An organic EL display device (1) includes a first substrate (30), a second substrate (20) facing the first substrate (30), an organic EL element (4) formed on the first substrate (30) and provided between the first substrate (30) and the second substrate (20), a sealing member (5) provided between the first substrate (30) and the second substrate (20), and configured to attach the first substrate (30) and the second substrate (20) together to seal the organic EL element (4), and an encapsulation resin (14) formed on the second substrate (20), provided between the first substrate (30) and the second substrate (20), and configured to cover a surface of the organic EL element (4). The sealing member (5) and the encapsulation resin (14) are separated apart from each other in a plane direction X of the organic EL display device (1).

## Description

### TECHNICAL FIELD

The present invention relates to organic EL display devices including organic electric field light emitting elements (organic electroluminescence elements: hereinafter referred to as "organic EL elements"), and methods for manufacturing the organic EL display devices.

### BACKGROUND ART

In recent years, organic EL display devices have received attention as a next-generation flat panel display device. The organic EL display device emits light by itself, and has excellent viewing angle characteristics, high visibility, low power consumption, and a small thickness. Therefore, there is an increasing demand for the organic EL display device.

The organic EL display device includes a plurality of organic EL elements arranged in a predetermined pattern. Each organic EL element includes a first electrode (anode) formed on an insulating substrate, an organic layer having a light emitting layer formed on the first electrode, and a second electrode (cathode) formed on the organic layer.

Here, the organic EL element typically has a problem that after being driven for a certain period of time, characteristics of light emission, such as luminance, uniformity, etc., significantly decrease from the initial levels. Examples of causes for the decrease in light emission characteristics include degradation of the organic layer caused by water contained in ambient air entering the organic EL element, oxidation of the electrodes caused by oxygen contained in ambient air, detachment of the organic layer and the electrodes caused by the water and oxygen, etc.

In an effort to address the above problem, an organic EL display device has been proposed which is configured to remove the water and oxygen. More specifically, for example, an organic EL display device has been described which includes an organic EL element in which an organic layer is interposed between a pair of electrodes facing each other, a hermetic container which houses the organic EL element and shuts out ambient air, and drying means which is provided in the hermetic container and separated apart from the organic EL element, and chemically absorbs water (see, for example, PATENT DOCUMENT 1).

Also, for example, an organic EL display device has been described which includes a first electrode, an organic layer formed on the first electrode, a second electrode formed on the organic layer with the organic layer being interposed between the first electrode and the second electrode, and a sealing member formed to seal the organic layer. A deoxidation/dehydration member containing an alkali metal or an alkaline-earth metal is formed at any position in a space sealed by the sealing member (see, for example, PATENT DOCUMENT 2).

However, in the organic EL display device of PATENT DOCUMENT 1, although water in the hermetic container can be removed, disadvantageously water cannot be removed from the organic layer. In the organic EL display device of PATENT DOCUMENT 2, the alkali metal or alkaline-earth metal contained in the deoxidation/dehydration member is highly reactive to water and oxygen and therefore is unstable, and therefore, disadvantageously a stable level of durability is not obtained.

Therefore, an organic EL display device has been proposed which includes an encapsulation resin for protecting the organic EL element from water and oxygen. More specifically, an organic EL display device has been described which includes an encapsulation resin for encapsulating a light emission region of the organic EL element formed on an element substrate, and a sealing member provided on a sealing substrate and functioning as a protective wall to blocking a light emission region from an electrode region. It has been described that, with such a configuration, even when the encapsulation resin for protecting the organic EL element from water and oxygen is applied and formed in the light emission region, the sealing member can prevent an uncured encapsulation resin from spreading into the electrode region (see, for example, PATENT DOCUMENT 3).

### CITATION LIST

### PATENT DOCUMENTS

PATENT DOCUMENT 1: Japanese Patent Publication No. H09-148066
PATENT DOCUMENT 2: Japanese Patent Publication No. 2002-8852
PATENT DOCUMENT 3: Japanese Patent No. 3705190

### SUMMARY OF THE INVENTION

### TECHNICAL PROBLEM

However, in the organic EL display device of PATENT DOCUMENT 3, the encapsulation resin is applied onto a surface of the organic EL element provided on the element substrate. Therefore, it is difficult to control the thickness of the encapsulation resin between the element substrate and the sealing substrate, resulting in a disadvantageous decrease in display performance.

More specifically, in the element substrate, the display region and the surrounding region have different levels of surface roughness, and therefore, the encapsulation resin formed on the element substrate does not have a uniform thickness. When the element substrate and the sealing substrate are attached together while the encapsulation resin has a non-uniform height, the distance between the substrates significantly differs between the display region and the surrounding region. Moreover, in the display region, one of the substrates is locally raised (bumps occur) due to the surface roughness, so that the distance between the substrates locally increases. As a result, the distance between the substrates significantly differs between the display region and the surrounding region, so that display unevenness occurs, resulting in a disadvantageous degradation in display performance.

When the encapsulation resin is applied onto the surface of the organic EL element, application marks occur in the display region, resulting in a disadvantage degradation in display quality of the organic EL display device.

When the element substrate and the sealing substrate are attached together, the sealing member and the encapsulation resin contact each other. Therefore, in a region where the sealing member and the encapsulation resin contact each other, the uncured encapsulation resin physically mixes with the sealing member, so that the sealing member is dissolved in the uncured encapsulation resin (compatibilization), and disadvantageously, outgassing occurs due to the compatibilization.

Moreover, when the element substrate and the sealing substrate are attached together, a gas outgassed from a material for the encapsulation resin etc. causes an excessive increase in the internal pressure of the organic EL display device, resulting in disadvantageous damage occurring at an interface between the encapsulation resin and the sealing member.

Therefore, the present invention has been made in view of the above problems. It is an object of the present invention to provide an organic EL display device which can reduce or prevent a degradation in display performance, compatibilization caused by mixture of the encapsulation resin and the sealing member, and damage caused by outgassing, and to provide a method for manufacturing the organic EL display device.

### SOLUTION TO THE PROBLEM

To achieve the object, an organic EL display device of the present invention includes a first substrate, a second substrate facing the first substrate, an organic EL element formed on the first substrate and provided between the first substrate and the second substrate, a sealing member provided between the first substrate and the second substrate, and configured to attach the first substrate and the second substrate together to seal the organic EL element, and an encapsulation resin formed on the second substrate, provided between the first substrate and the second substrate, and configured to cover a surface of the organic EL element. The sealing member and the encapsulation resin are separated apart from each other in a plane direction of the organic EL display device.

With this configuration, the encapsulation resin is formed on the second substrate. Therefore, unlike the aforementioned conventional technique, it is no longer necessary to apply the encapsulation resin onto the surface of the first substrate on which the organic EL element has been formed, and therefore, it is easier to control the thickness of the encapsulation resin between the first substrate and the second substrate. As a result, a reduction in the display performance of the organic EL display device can be reduced or prevented.

Also, because the encapsulation resin is formed on the second substrate, it is no longer necessary to apply the encapsulation resin onto the surface of the organic EL element provided on the first substrate. Therefore, application marks occurring in a display region can be reduced or prevented, and therefore, a degradation in the display quality of the organic EL display device caused by the application marks can be reduced or prevented.

The sealing member and the encapsulation resin are separated apart from each other in the plane direction of the organic EL display device. Therefore, when the first substrate and the second substrate are attached together, the sealing member and the encapsulation resin can be prevented from contacting each other. As a result, it is possible to reduce or prevent the phenomenon (compatibilization) that the uncured encapsulation resin physically mixes with the sealing member, so that the sealing member is dissolved in the uncured encapsulation resin. The reduction or prevention of the compatibilization can reduce or prevent outgassing of the unreacted material due to the compatibilization.

Also, because the sealing member and the encapsulation resin are separated apart from each other, a space is formed between the sealing member and the encapsulation resin. Therefore, when the first substrate and the second substrate are attached together, even if outgassing occurs in the material for the encapsulation resin etc., a generated gas can efficiently escape to the space. As a result, it is possible to solve the problem that the outgassing excessively increases the pressure of the inside of the organic EL display device, so that damage occurs at an interface between the encapsulation resin and the sealing member.

In the organic EL display device of the present invention, a relationship 0.5L + 0.1T ≤ E ≤ 50T may be established, where T is a thickness of the encapsulation resin, E is a distance between the sealing member and the encapsulation resin in the plane direction, and L is a width of the sealing member.

With this configuration, the compatibilization can be reduced or prevented without raising the problem that the size of the organic EL display device increases, whereby an increase in the internal pressure of the organic EL display device due to outgassing can be reduced or prevented.

In the organic EL display device of the present invention, the thickness of the encapsulation resin may be in a range of 1 µm to 100 µm, both inclusive.

With this configuration, a sufficient level of durability of the organic EL element can be ensured.

In the organic EL display device of the present invention, the encapsulation resin may be formed of an ultraviolet curable resin.

With this configuration, the number of steps of producing the encapsulation resin can be reduced and therefore the encapsulation resin can be more easily formed.

In the organic EL display device of the present invention, the encapsulation resin may be formed of an acrylic resin or an epoxy resin.

With this configuration, the encapsulation resin can be formed of a low-cost and versatile resin material.

In the organic EL display device of the present invention, a light blocking member having a capability of transmitting visible light and a capability of blocking ultraviolet light may be provided on a surface of the organic EL element.

With this configuration, for example, when the encapsulation resin and the sealing member are formed by irradiation with ultraviolet light, ultraviolet light entering the organic EL element can be reliably reduced or prevented. As a result, a degradation in the organic EL element caused by irradiation with ultraviolet light can be reduced or prevented. Also, the light blocking member has a capability of transmitting visible light, and therefore, the organic EL display device is applicable to any of the following types: bottom emission type, in which light is extracted through the first substrate; top emission type, in which light is extracted through the second substrate; and double-sided emission type, in which light is extracted through both the first substrate and the second substrate.

A method for manufacturing an organic EL display device of the present invention includes at least an organic EL element formation step of forming an organic EL element on a first substrate, a sealing member formation step of forming a frame-like sealing member on a second substrate, a resin material application step of applying a resin material for forming an encapsulation resin to an inside of the sealing member formed on the second substrate, where the resin material is separated apart from the sealing member, a two-substrate structure formation step of attaching the first substrate and the second substrate together with the sealing member being interposed therebetween, in a vacuum atmosphere, and allowing the resin material to uniformly spread inside the sealing member, a resin curing step of curing the resin material to form the encapsulation resin on the second substrate, and curing the resin for forming the sealing member, where the sealing member and the encapsulation resin are separated apart from each other in the plane direction of organic EL display device.

With this configuration, the encapsulation resin is formed on the second substrate. Therefore, unlike the aforementioned conventional technique, it is no longer necessary to apply the encapsulation resin onto the surface of the first substrate on which the organic EL element has been formed, and therefore, it is easier to control the thickness of the encapsulation resin between the first substrate and the second substrate. As a result, a reduction in the display performance of the organic EL display device can be reduced or prevented.

Also, because the encapsulation resin is formed on the second substrate, it is no longer necessary to apply the encapsulation resin onto the surface of the organic EL element provided on the first substrate. Therefore, application marks occurring in a display region can be reduced or prevented, and therefore, a degradation in the display quality of the organic EL display device caused by the application marks can be reduced or prevented.

The sealing member and the encapsulation resin are separated apart from each other in the plane direction of the organic EL display device. Therefore, when the first substrate and the second substrate are attached together, the sealing member and the encapsulation resin can be prevented from contacting each other. As a result, it is possible to reduce or prevent the phenomenon (compatibilization) that the uncured encapsulation resin physically mixes with the sealing member, so that the sealing member is dissolved in the uncured encapsulation resin. The reduction or prevention of the compatibilization can reduce or prevent outgassing of the unreacted material due to the compatibilization.

Also, because the sealing member and the encapsulation resin are separated apart from each other, a space is formed between the sealing member and the encapsulation resin. Therefore, when the first substrate and the second substrate are attached together, even if outgassing occurs in the material for the encapsulation resin etc., a generated gas can efficiently escape to the space. As a result, it is possible to solve the problem that the outgassing excessively increases the pressure of the inside of the organic EL display device, so that damage occurs at an interface between the encapsulation resin and the sealing member.

In the organic EL display device manufacturing method of the present invention, in the resin curing step, the sealing member and the encapsulation resin may be separated apart from each other so that a relationship 0.5L + 0.1T ≤ E ≤ 50T may be established, where T is a thickness of the encapsulation resin, E is a distance between the sealing member and the encapsulation resin in the plane direction, and L is a width of the sealing member.

With this configuration, the compatibilization can be reduced or prevented without raising the problem that the size of the organic EL display device increases, whereby an increase in the internal pressure of the organic EL display device due to outgassing can be reduced or prevented.

In the organic EL display device manufacturing method of the present invention, in the resin material application step, the resin material may be dropped and injected inside the sealing member.

With this configuration, when the resin material for the encapsulation resin is applied, the sealing member and the resin material formed on the sealing substrate can be easily prevented from contacting each other.

In the organic EL display device manufacturing method of the present invention, in the resin curing step, heating may be performed.

With this configuration, the sealing member and the encapsulation resin thermally contract, and therefore, a space can be reliably formed between the sealing member and the resin material, and the sealing member and the encapsulation resin can be reliably separated apart from each other.

### ADVANTAGES OF THE INVENTION

According to the present invention, in an organic EL display device including an encapsulation resin and a sealing member, a degradation in display performance can be reduced or prevented, and the compatibilization caused by mixture of the encapsulation resin and the sealing member can be reduced or prevented. Also, damage due to outgassing can be reduced or prevented.

### BRIEF DESCRIPTION OF THE DRAWINGS

[FIG. 1] FIG. 1 is a plan view of an organic EL display device according to an embodiment of the present invention.
[FIG. 2] FIG. 2 is a cross-sectional view taken along line A-A of FIG. 1.
[FIG. 3] FIG. 3 is a cross-sectional view for describing an organic layer included in an organic EL element provided in the organic EL display device of the embodiment of the present invention.
[FIG. 4] FIG. 4 is a diagram for describing a method for manufacturing the organic EL display device of the embodiment of the present invention.
[FIG. 5] FIG. 5 is a diagram for describing the method for manufacturing the organic EL display device of the embodiment of the present invention.
[FIG. 6] FIG. 6 is a diagram for describing the method for manufacturing the organic EL display device of the embodiment of the present invention.
[FIG. 7] FIG. 7 is a diagram for describing the method for manufacturing the organic EL display device of the embodiment of the present invention.
[FIG. 8] FIG. 8 is a diagram for describing the method for manufacturing the organic EL display device of the embodiment of the present invention.
[FIG. 9] FIG. 9 is a diagram for describing the method for manufacturing the organic EL display device of the embodiment of the present invention.
[FIG. 10] FIG. 10 is a diagram for describing the method for manufacturing the organic EL display device of the embodiment of the present invention.
[FIG. 11] FIG. 11 is a diagram for describing the method for manufacturing the organic EL display device of the embodiment of the present invention.
[FIG. 12] FIG. 12 is a diagram for describing the method for manufacturing the organic EL display device of the embodiment of the present invention.
[FIG. 13] FIG. 13 is a diagram for describing the method for manufacturing the organic EL display device of the embodiment of the present invention.
[FIG. 14] FIG. 14 is a cross-sectional view for describing a variation of the organic EL display device of the present invention.

### DESCRIPTION OF EMBODIMENTS

An embodiment of the present invention will be described in detail hereinafter with reference to the accompanying drawings. Note that the present invention is not limited to the embodiments described below.

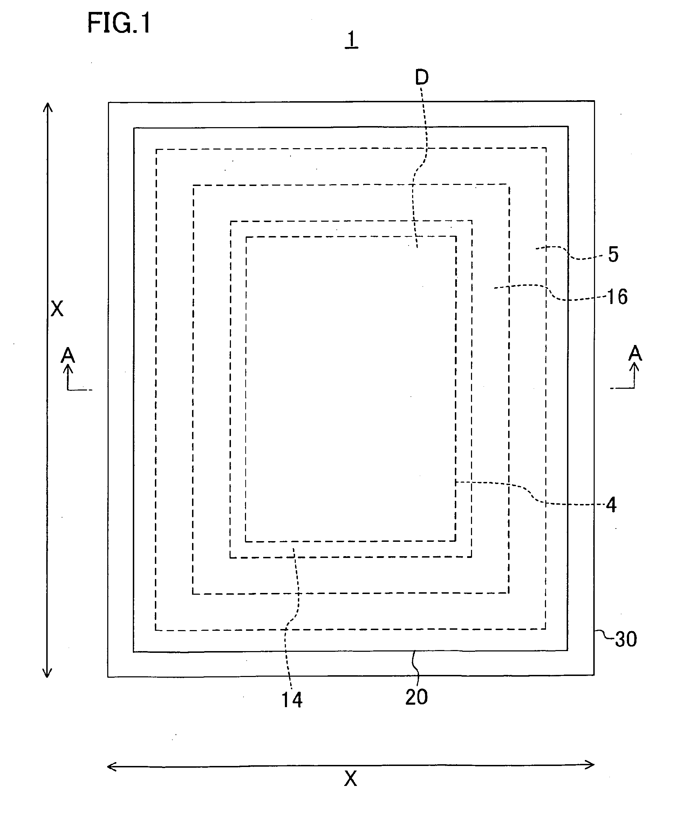

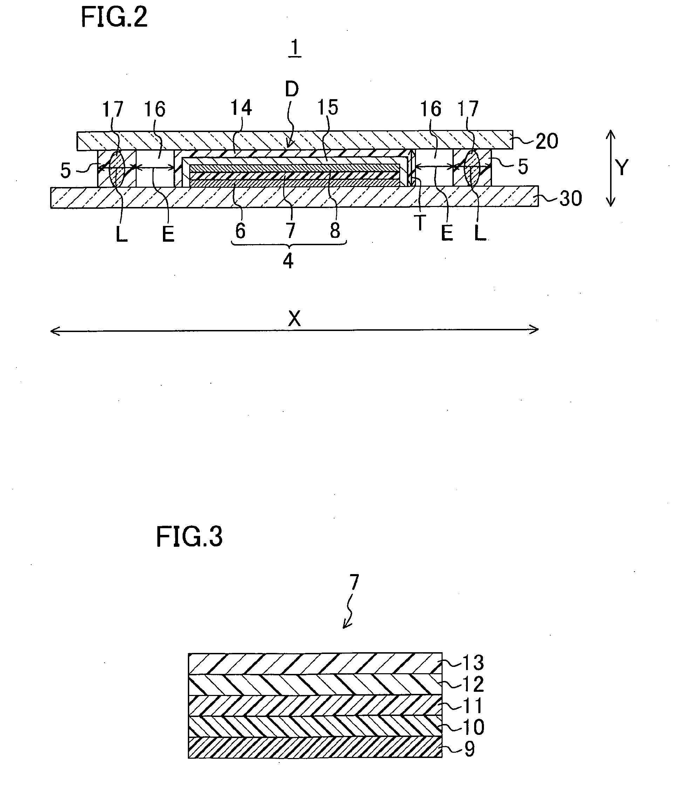

FIG. 1 is a plan view of an organic EL display device according to the embodiment of the present invention. FIG. 2 is a cross-sectional view taken along line A-A of FIG. 1. FIG. 3 is a cross-sectional view for describing an organic layer included in an organic EL element provided in the organic EL display device of the embodiment of the present invention.

As shown in FIGS. 1 and 2, the organic EL display device 1 includes an element substrate 30 (first substrate), a sealing substrate 20 (second substrate) facing the element substrate 30, and an organic EL element 4 which is formed on the element substrate 30 and provided between the element substrate 30 and the sealing substrate 20. The organic EL display device 1 further includes a sealing member 5 which is provided between the element substrate 30 and the sealing substrate 20 and is used to attach the element substrate 30 and the sealing substrate 20 together to seal the organic EL element 4. The sealing member 5 is formed in the shape of a frame extending along a circumference of the organic EL element 4. The element substrate 30 and the sealing substrate 20 are attached to each other via the first sealing member 5.

As shown in FIGS. 1 and 2, the organic EL element 4 is provided on the element substrate 30, and the element substrate 30 has a display region D surrounded by the sealing member 5. In the display region D, the organic EL element 4 is provided and formed in a matrix on a surface of the element substrate 30 facing the sealing substrate 20.

The element substrate 30 and the sealing substrate 20 are formed of, for example, an insulating material, such as glass, plastic, etc.

As shown in FIG. 2, the organic EL element 4 includes a first electrode 6 (anode) provided on a surface of the element substrate 30, an organic layer 7 provided on a surface of the first electrode 6, and a second electrode 8 (cathode) provided on a surface of the organic layer 7.

There are a plurality of the first electrodes 6 spaced at predetermined intervals and arranged in a matrix on the surface of the element substrate 30. Each of the first electrodes 6 forms a corresponding pixel region of the organic EL display device 1. Note that the first electrode 6 is formed of, for example, Au, Ni, Pt, ITO (indium-tin oxide), a multilayer film of ITO and Ag, or the like.

The organic layer 7 is formed on the surface of each of the first electrodes 6 arranged in a matrix. As shown in FIG. 3, the organic layer 7 includes a hole injection layer 9, a hole transport layer 10 formed on a surface of the hole injection layer 9, a light emitting layer 11 formed on a surface of the hole transport layer 10 and for emitting any of red, green, and blue light, an electron transport layer 12 formed on a surface of the light emitting layer 11, and an electron injection layer 13 formed on a surface of the electron transport layer 12. The hole injection layer 9, the hole transport layer 10, the light emitting layer 11, the electron transport layer 12, and the electron injection layer 13 are successively stacked to form the organic layer 7.

The hole injection layer 9 is used to enhance the efficiency of injection of holes into the light emitting layer 11. Examples of a material for the hole injection layer 9 include benzine, styrylamine, triphenylamine, porphyrin, triazole, imidazole, oxadiazole, polyarylalkane, phenylenediamine, arylamine, oxazole, anthracene, fluorenone, hydrazone, stilbene, triphenylene, azatriphenylene, or derivatives thereof, or heterocyclic conjugated monomers, oligomers, or polymers, such as polysilane compounds, vinylcarbazole compounds, thiophene compounds, aniline-based compounds, etc.

Similar to the hole injection layer 9, the hole transport layer 10 is used to enhance the efficiency of injection of holes into the light emitting layer 11. The hole transport layer 10 may be made of a material similar to that for the hole injection layer 9.

When a voltage is applied to the light emitting layer 11 via the first electrode 6 and the second electrode 8, holes and electrons are injected from the electrodes into the light emitting layer 11, in which the holes and the electrons are recombined. The light emitting layer 11 is formed of a material having a high light emission efficiency. Examples of such a material include organic materials, such as low molecular-weight fluorescent dyes, fluorescent macromolecules, metal complexes, etc. More specifically, examples of the material include anthracene, naphthalene, indene, phenanthrene, pyrene, naphthacene, triphenylene, anthracene, perylene, picene, fluoranthene, acephenanthrylene, pentaphene, pentacene, coronene, butadiene, coumarin, acridine, stilbene, or derivatives thereof, tris(8-quinolinato)aluminum complex, bis(benzoquinolinato)beryllium complex, tri(dibenzoylmethyl)phenanthroline europium complex, and ditoluylvinylbiphenyl.

The electron transport layer 12 is used to transport electrons injected from the second electrode 8 to the light emitting layer 11. Examples of a material for the electron transport layer 12 include quinoline, perylene, phenanthroline, bisstyryl, pyrazine, triazole, oxazole, oxadiazole, fluorenone, or derivatives and metal complexes thereof. More specifically, examples of the material include tris(8-hydroxyquinoline)aluminum , anthracene, naphthalene, phenanthrene, pyrene, anthracene, perylene, butadiene, coumarin, acridine, stilbene, 1,10-phenanthroline, or derivatives and metal complexes thereof.

Similar to the electron transport layer 12, the electron injection layer 13 is used to transfer electrons injected from the second electrode 8 to the light emitting layer 11. The electron injection layer 13 is formed of a material similar to that for the electron transport layer 12.

The second electrode 8 has a function of injecting electrons into the organic layer 7. The second electrode 8 is formed of, for example, a magnesium alloy (e.g., MgAg etc.), an aluminum alloy (e.g., AlLi, AlCa, AlMg, etc.), metallic calcium, a metal having a low work function, etc.

The sealing member 5 which is used to attach the element substrate 30 and the sealing substrate 20 together is used to fix the element substrate 30 and the sealing substrate 20 to each other. Examples of the resin forming the sealing member 5 includes ultraviolet curable resins and thermosetting resins, such as acrylic resins, epoxy resins, etc.

The sealing member 5 contains a spacer 17 (see FIG. 2) which regulates a distance between the element substrate 30 and the sealing substrate 20 (i.e., a thickness of an encapsulation resin 14). The spacer 17 is formed of, for example, SiO₂ (silicon oxide).

As shown in FIG. 2, the organic EL display device 1 also includes an encapsulation resin 14 formed of a resin. The encapsulation resin 14 is used to protect the organic EL element 4 from water and oxygen. Examples of the resin included in the encapsulation resin 14 include, but are not particularly limited to, ultraviolet curable resins, thermosetting resins, two-component curable resins, water curable resins, anaerobic curable resins, hot melt resins, etc. Of these resins, ultraviolet light curable, thermosetting, and two-component curable epoxy resins having water and oxygen permeability are preferably used. Ultraviolet curable resins are preferably used because the number of steps of producing the encapsulation resin 14 can be reduced and therefore the encapsulation resin 14 can be easily formed. The thickness T of the encapsulation resin 14 is preferably 1-100 µm because a sufficient level of durability of the organic EL element 4 can be ensured.

Note that, in this embodiment, as shown in FIG. 2, a protection film 15 which prevents the organic EL element 4 and the encapsulation resin 14 from contacting each other to protect the organic EL element 4 is formed on the organic EL element 4. The protection film 15 is formed of, for example, an inorganic material, such as SiO₂, SiON, etc.

Here, in the organic EL display device 1 of this embodiment, as shown in FIG. 2, an encapsulation resin 14 is formed on the sealing substrate 20 and is provided between the element substrate 30 and the sealing substrate 20.

With such a configuration, unlike the aforementioned conventional technique, it is no longer necessary to apply the encapsulation resin 14 onto the surface of the organic EL element 4 provided on the element substrate 30. Therefore, it is easier to control the thickness of the encapsulation resin 14 between the element substrate 30 and the sealing substrate 20.

Specifically, because the encapsulation resin 14 is formed on the sealing substrate 20, even if the degree of the surface roughness differs between the surfaces of the display region D and the surrounding region in the element substrate 30, the encapsulation resin 14 having a uniform thickness can be formed on the sealing substrate 20. The uniform thickness of the encapsulation resin 14 allows the distance between the element substrate 30 and the sealing substrate 20 to be uniform over the display region D and the surrounding region even when the element substrate 30 and the sealing substrate 20 are attached together. Also, bumps occurring on one of the substrates due to the surface roughness in the display region D can be reduced or prevented. Therefore, it is possible to reduce or prevent a local increase in the distance between the element substrate 30 and the sealing substrate 20. Therefore, the distance between the substrates does not significantly differ between the display region D and the surrounding region, and therefore, display unevenness can be reduced or prevented.

Also, because the encapsulation resin 14 is formed on the sealing substrate 20, it is no longer necessary to apply the encapsulation resin 14 onto the surface of the organic EL element 4 provided on the element substrate 30. Therefore, application marks occurring in the display region D (i.e., application marks of the resin material of the encapsulation resin 14) can be reduced or prevented.

In the organic EL display device 1 of this embodiment, as shown in FIGS. 1 and 2, the sealing member 5 and the encapsulation resin 14 are separated apart from each other in a plane direction X of the organic EL display device 1. In other words, a space 16 is formed between the sealing member 5 and a resin material 14a (i.e., the encapsulation resin 14) in the plane direction X of the organic EL display device 1.

With such a configuration, when the element subsume 30 and the sealing substrate 20 are attached together, the sealing member 5 and the encapsulation resin 14 can be prevented from contacting each other. Therefore, it is possible to reduce or prevent a phenomenon (compatibilization) that the uncured encapsulation resin 14 physically mixes with the sealing member 5, so that the sealing member 5 is dissolved in the uncured encapsulation resin 14.

The reduction or prevention of the compatibilization can reduce or prevent outgassing of the unreacted material due to the compatibilization.

Because the sealing member 5 and the encapsulation resin 14 are separated apart from each other, a space 16 is formed between the sealing member 5 and the encapsulation resin 14. Therefore, when the element substrate 30 and the sealing substrate 20 are attached together, then even if outgassing occurs in a material for the encapsulation resin 14 etc., a generated gas can efficiently escape to the space 16.

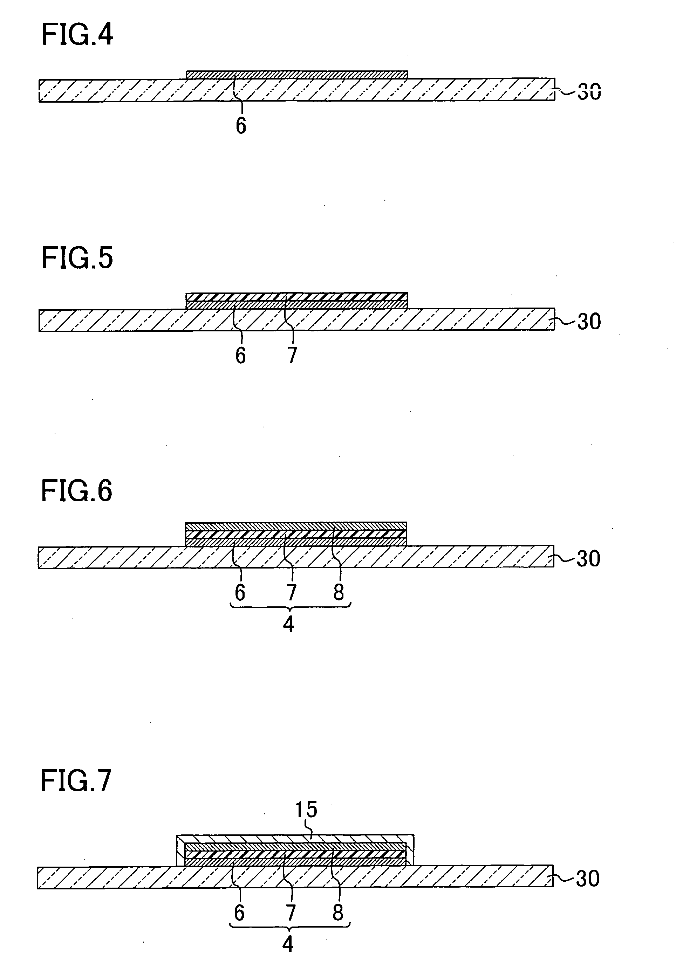

Next, an example method for manufacturing the organic EL display device of this embodiment will be described. FIGS. 4-13 are diagrams for describing a method for manufacturing the organic EL display device of the embodiment of the present invention.

### <Organic EL Element Formation Step>

Initially, as shown in FIG. 4, the first electrode 6 is formed on the element substrate 30 which is, for example, a glass substrate having a substrate size of 300 × 400 mm and a thickness of 0.7 mm, by forming a patterned ITO film by sputtering. In this case, the first electrode 6 has a thickness of, for example, about 150 nm.

Next, the organic layer 7 including the light emitting layer 11, and the second electrode 8, are formed on the first electrode 6 by vapor deposition using a metal mask.

More specifically, initially, the element substrate 30 including the first electrode 6 is placed in a chamber of a vapor deposition apparatus. Note that the inside of the chamber of the vapor deposition apparatus is kept at a vacuum degree of 1 × 10⁻⁶ to 1 × 10⁻⁴ (Pa) using a vacuum pump. The element substrate 30 including the first electrode 6 is held by a pair of supports attached to the inside of the chamber with two edges of the element substrate 30 being fixed to the supports.

Thereafter, vapor deposition materials for the hole injection layer 9, the hole transport layer 10, the light emitting layer 11, the electron transport layer 12, and the electron injection layer 13 are successively vaporized from a vapor deposition source to form and stack the hole injection layer 9, the hole transport layer 10, the light emitting layer 11, the electron transport layer 12, and the electron injection layer 13. As a result, as shown in FIG. 5, the organic layer 7 is formed on the first electrode 6 in the pixel region.

Thereafter, as shown in FIG. 6, the second electrode 8 is formed on the organic layer 7. Thus, the organic EL element 4 including the first electrode 6, the organic layer 7, and the second electrode 8 is formed on the element substrate 30.

Note that the vapor deposition source may be, for example, a crucible containing the vapor deposition materials. The crucible is placed in a lower portion inside the chamber. The crucible has a heater which heats the crucible. If the internal temperature of the crucible reaches the vaporization temperature of each vapor deposition material by heat of the heater, the vapor deposition material contained in the crucible is vaporized, i.e., the vaporized molecules escape upward from the material in the chamber.

The organic layer 7 and the second electrode 8 are specifically formed as follows. Initially, the hole injection layer 9 made of m-MTDATA (4,4,4-tris(3-methylphenylphenylamino)triphenylamine) having a thickness of, for example, 25 nm, which is common to all R, G, and B pixels, is formed on the patterned first electrode 6 provided on the element substrate 30 using a mask. Next, the hole transport layer 10 made of α-NPD(4,4-bis(N-1-naphthyl-N-phenylamino)biphenyl) having a thickness of, for example, 30 nm, which is common to all R, G, and B pixels, is formed on the hole injection layer 9 using a mask. Next, as the light emitting layer 11 for a red color, a mixture of di(2-naphthyl)anthracene (ADN) and 2,6-bis((4'-methoxydiphenylamino)styryl)-1,5-dicyanonaphthalene (BSN) (30 wt %) having a thickness of, for example, 30 nm is formed on the hole transport layer 10 formed in the corresponding pixel regions using a mask. Next, as the light emitting layer 11 for a green color, a mixture of ADN and coumarin 6 (5 wt %) having a thickness of, for example, 30 nm is formed on the hole transport layer 10 formed on the corresponding pixel regions using a mask. Next, the light emitting layer 11 as a blue color, a mixture of ADN and 4,4'-bis(2-{4-(N,N-diphenylamino)phenyl}vinyl)biphenyl (DPAVBi) (2.5 wt %) having a thickness of, for example, 30 nm is formed on the hole transport layer 10 formed on the corresponding pixel regions using mask. Next, as the electron transport layer 12, 8-hydroxyquinolinealuminum (Alq3) having a thickness of, for example, 20 nm, which is common to all R, G, and B pixels, is formed on each light emitting layer 11 using a mask. Next, as the electron injection layer 13, lithium fluoride (LiF) having a thickness of, for example, 0.3 nm is formed on the electron transport layer 12 using a mask. Thereafter, as the second electrode 8, a cathode made of magnesium silver (MgAg) having a thickness of, for example, 10 nm is formed.

Next, as shown in FIG. 7, the protection film 15 for protecting the organic EL element 4 is formed on a surface of the organic EL element 4. The protection film 15 may be formed by forming a layer made of an inorganic material, such as SiO₂, SiON, etc., on the surface of the organic EL element 4 by vapor deposition, sputtering, chemical vapor deposition, etc.

### <Sealing Member Formation Step>

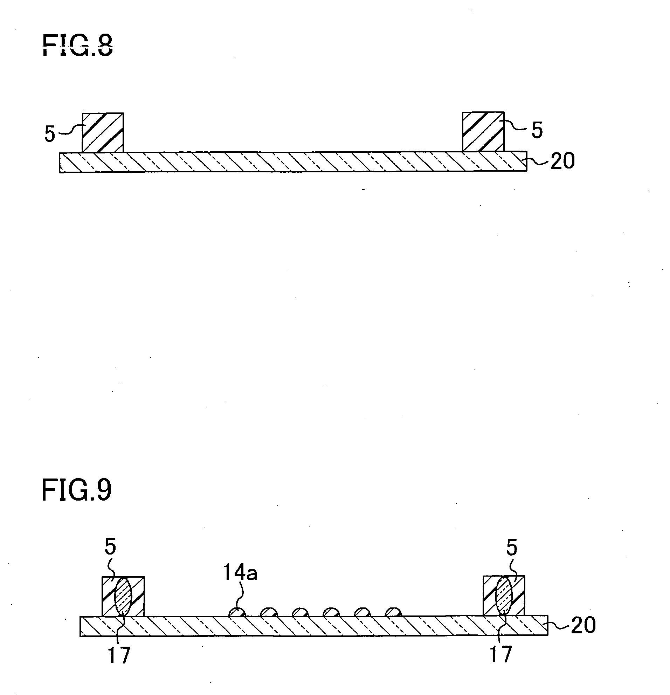

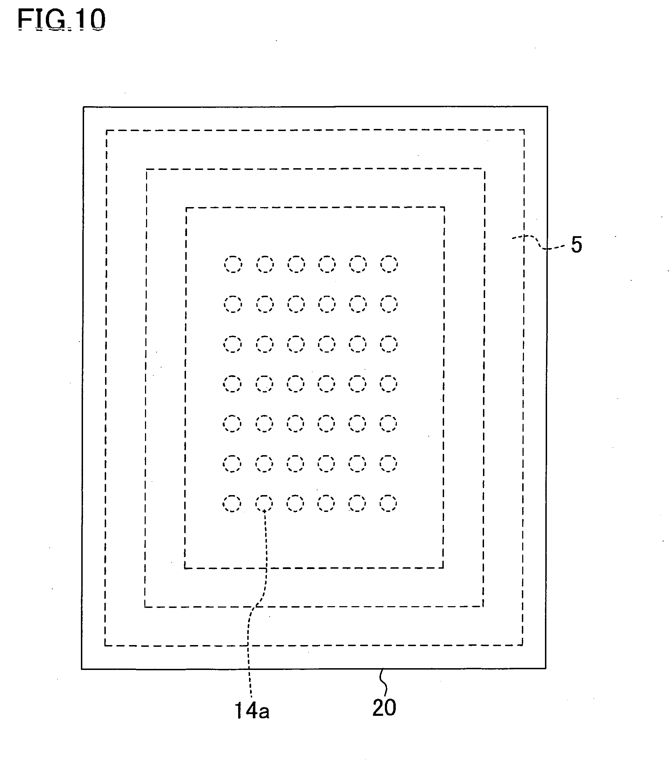

Initially, as shown in FIGS. 8 and 10, a material described above, such as an epoxy resin etc., is applied onto the sealing substrate 20 (e.g., a glass substrate having a substrate size of 730 mm × 920 mm and a thickness of 0.7 mm) by using a dispenser, mask printing, flexography, etc. to form the frame-like sealing member 5.

### <Resin Material Application Step (One Drop Filling Step)>

Next, a resin material for forming the encapsulation resin 14 is applied to the inside of the sealing member 5 formed on the sealing substrate 20 by using a dispenser, mask printing, one drop filling, etc. In this case, the applied resin material is separated apart from the sealing member 5. Here, in this embodiment, as described above, in order to separate the sealing member 5 and the encapsulation resin 14 apart from each other, the resin material for forming the encapsulation resin 14 is preferably applied by dropping and injecting the resin material to the inside of the sealing member 5 so that the sealing member 5 and the resin material formed on the sealing substrate 20 are easily prevented from contacting each other.

In this case, as shown in FIGS. 9 and 10, the resin material 14a for forming the encapsulation resin 14 is dropped and injected inside the sealing member 5 formed on the sealing substrate 20. Note that the resin material 14a is, for example, an ultraviolet curable resin, such as an acrylic resin, an epoxy resin, etc., or a two-component curable resin, such as an epoxy resin etc.

The resin material 14a is dropped by, for example, a dropping apparatus which has a function of dropping the resin material 14a dropping the resin material 14a while moving over the entire substrate surface. In order to reliably prevent the resin material 14a from contacting the sealing member 5, the resin material 14a should not be dropped from the vicinity of the sealing member 5.

Also, the viscosity of the resin material 14a is preferably adjusted before the dropping in order to prevent the sealing member 5 and the encapsulation resin 14 from contacting each other so that the sealing member 5 and the encapsulation resin 14 are reliably separated apart from each other. More specifically, for example, by increasing the viscosity of the resin material 14a to be dropped, spreading of the dropped resin material 14a on the surface of the sealing substrate 20 inside the sealing member 5 may be reduced or prevented. Alternatively, by decreasing the viscosity of the resin material 14a to be dropped, the resin material 14a may be dropped and concentrated to the vicinity of a center portion of the sealing substrate 20 inside the sealing member 5.

For example, when a distance E between the sealing member 5 and the encapsulation resin 14 in the plane direction X of the organic EL display device 1 is set to 0.1 mm or more, the resin material 14a of 10-20 Pa·s is used. When the viscosity is set to such values, although the resin material 14a dropped on the plane of the sealing substrate 20 spreads over a certain distance until the resin material 14a is cured (processing time: e.g., two hours), the sealing member 5 and the encapsulation resin 14 are prevented from contacting each other, so that the sealing member 5 and the encapsulation resin 14 can be reliably separated apart from each other.

### <Two-substrate Structure Formation Step>

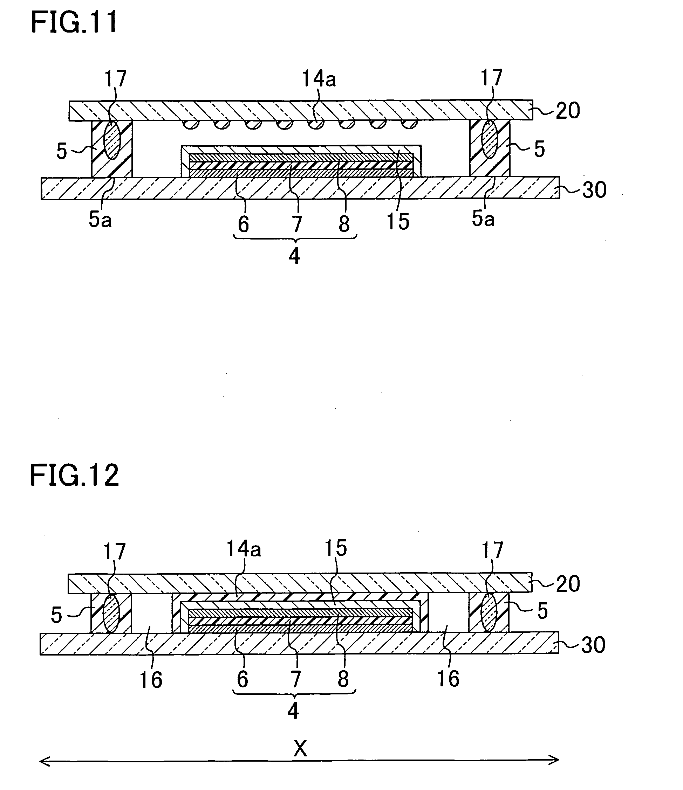

Next, in a vacuum atmosphere, the sealing substrate 20 on which the sealing member 5 has been formed, and the element substrate 30 on which the organic EL element 4 has been formed, are attached together. Specifically, the sealing substrate 20 is put on the element substrate 30 with the resin material 14a being located directly above the organic EL element 4. As shown in FIG. 11, a surface 5a of the sealing member 5 formed on the sealing substrate 20 is put on the element substrate 30.

Next, as shown in FIG. 12, in a vacuum atmosphere, the hermetic (vacuum) state of the inside of the sealing member 5 is maintained under a predetermined condition (e.g., under a pressure of 100 Pa or less). Thereafter, while the hermetic (vacuum) state is maintained, nitrogen leakage is performed and purging is performed to atmospheric pressure. Thus, by applying a differential pressure, the element substrate 30 and the sealing substrate 20 are attached together via the sealing member 5 to form a two-substrate structure in which the element substrate 30 and the sealing substrate 20 are attached together. Note that, when the element substrate 30 and the sealing substrate 20 are attached together, the dropped and injected resin material 14a is uniformly spread inside the sealing member 5 by applying a pressure, and as shown in FIG. 12, a space 16 is formed between the sealing member 5 and the resin material 14a in the plane direction of the organic EL display device 1.

### <Resin Curing Step>

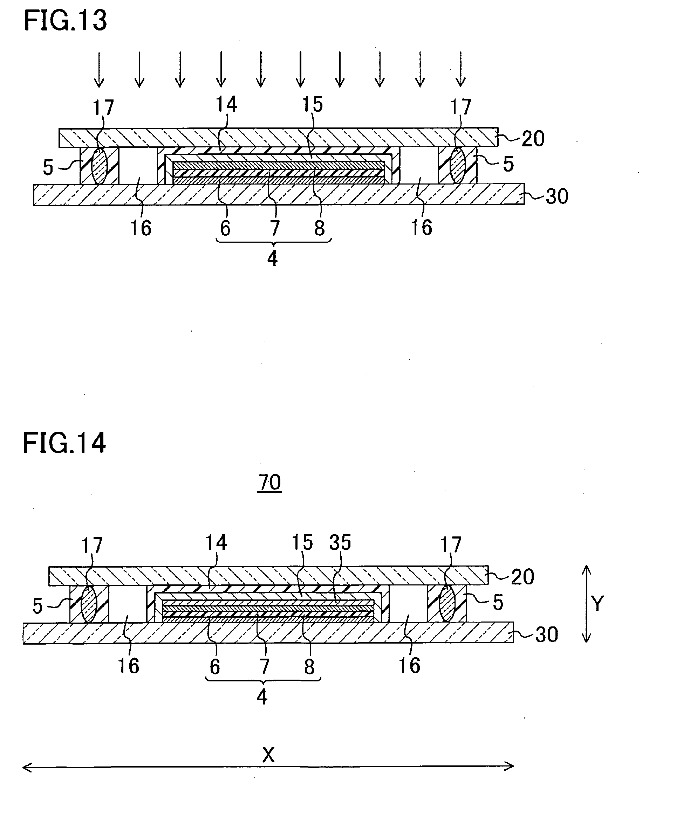

Next, as shown in FIG. 13, the two-substrate structure is irradiated with ultraviolet light (indicated by arrows in FIG. 13) through the sealing substrate 20 to cure the uniformly spread resin material 14a to form the encapsulation resin 14 on the sealing substrate 20, and to cure the resin included in the sealing member 5. In this case, the sealing member 5 and the encapsulation resin 14 are separated apart from each other in the plane direction X of the organic EL display device 1.

Note that the irradiation with ultraviolet light is preferably 0.5-10 J, more preferably 1-6 J. After the irradiation with ultraviolet light, heating is performed in the atmosphere (at 70°C to 120°C, both inclusive, for 10 minutes to 2 hours, both inclusive) in order to accelerate curing of the resin. By this heating process, the sealing member 5 and the encapsulation resin 14 thermally contract, and therefore, the space 16 is reliably formed between the sealing member 5 and the resin material 14a, and the sealing member 5 and the encapsulation resin 14 are reliably separated apart from each other.

The sealing member 5 and the encapsulation resin 14 are preferably separated apart from each other so that a relationship 0.5L + 0.1T ≤ E ≤ 50T is established, where T is the thickness of the encapsulation resin 14, E is the distance between the sealing member 5 and the encapsulation resin 14 in the plane direction X of the organic EL display device 1, and L is a width of the sealing member 5. This is because when 0.5L + 0.1T > E, the space 16 formed between the sealing member 5 and the encapsulation resin 14 decreases, and therefore, when the element substrate 30 and the sealing substrate 20 are attached together, it may difficult to prevent the compatibilization, and it is also difficult to allow a gas outgassed from the material for the encapsulation resin 14 etc. to efficiently escape to the space 16. When 50T < E, the space 16 formed between the sealing member 5 and the encapsulation resin 14 increases, and therefore, it may be difficult to reduce the size of the organic EL display device.

Therefore, for example, when the width L of the sealing member 5 and the thickness T of the encapsulation resin 14 are set to 1000 µm and 20 µm, respectively, the distance E between the sealing member 5 and the encapsulation resin 14 in the plane direction X of the organic EL display device 1 is preferably set to be in a range of 502 µm to 1000 µm, both inclusive.

According to this embodiment described above, the following advantages can be obtained.
(1) In this embodiment, the encapsulation resin 14 is formed on the sealing substrate 20. Therefore, unlike the aforementioned conventional technique, it is no longer necessary to apply the encapsulation resin 14 onto the surface of the element substrate 30, and therefore, it is easier to control the thickness of the encapsulation resin 14 between the element substrate 30 and the sealing substrate 20. As a result, a reduction in the display performance of the organic EL display device 1 can be reduced or prevented.
(2) Because the encapsulation resin 14 is formed on the sealing substrate 20, it is no longer necessary to apply the encapsulation resin 14 onto the surface of the organic EL element 4 provided on the element substrate 30. Therefore, application marks occurring in the display region D can be reduced or prevented, and therefore, a degradation in the display quality of the organic EL display device 1 caused by the application marks can be reduced or prevented.
(3) The scaling member 5 and the encapsulation resin 14 are separated apart from each other in the plane direction X of the organic EL display device 1. Therefore, when the element substrate 30 and the sealing substrate 20 are attached together, the sealing member 5 and the encapsulation resin 14 can be prevented from contacting each other. Therefore, it is possible to reduce or prevent the phenomenon (compatibilization) that the uncured encapsulation resin 14 physically mixes with the sealing member 5, so that the sealing member 5 is dissolved in the uncured encapsulation resin 14. The reduction or prevention of the compatibilization can reduce or prevent outgassing of the unreacted material due to the compatibilization.
(4) The sealing member 5 and the encapsulation resin 14 are separated apart from each other in the plane direction X of the organic EL display device 1. Therefore, when the element substrate 30 and the sealing substrate 20 are attached together, the sealing member 5 and the encapsulation resin 14 can be prevented from contacting each other. Therefore, the encapsulation resin 14 can be prevented from overlapping the sealing member 5, i.e., the encapsulation resin 14 is prevented from being interposed between the element substrate 30 and the sealing member 5. As a result, a reduction in tightness between the sealing substrate 20 and the element substrate 30 can be reduced or prevented, whereby water and oxygen flowing in from the outside can be reduced or prevented, whereby damage to the organic EL element 4 can be reduced or avoided, and therefore, a degradation in the display quality of the organic EL display device 1 can be reduced or prevented.
(5) Because the sealing member 5 and the encapsulation resin 14 are separated apart from each other, the space 16 is formed between the sealing member 5 and the encapsulation resin 14. Therefore, when the element substrate 30 and the sealing substrate 20 are attached together, even if outgassing occurs in the material for the encapsulation resin 14 etc., a generated gas can efficiently escape to the space 16. As a result, it is possible to solve the problem that the outgassing excessively increases the pressure of the inside of the organic EL display device 1, so that damage occurs at an interface between the encapsulation resin 14 and the sealing member 5.
(6) In this embodiment, the thickness T of the encapsulation resin 14, the distance E between the sealing member 5 and the encapsulation resin 14, and the width L of the sealing member have the relationship 0.5L + 0.1T ≤ E ≤ 50T. Therefore, the compatibilization can be reduced or prevented without raising the problem that the size of the organic EL display device 1 increases, whereby an increase in the internal pressure of the organic EL display device 1 due to outgassing can be reduced or prevented.
(7) In this embodiment, the thickness of the encapsulation resin 14 is set to be in a range of 1 µm to 100 µm, both inclusive. Therefore, a sufficient level of durability of the organic EL element 4 can be ensured.
(8) In this embodiment, the encapsulation resin 14 is formed of an ultraviolet curable resin. Therefore, the number of steps of producing the encapsulation resin 14 can be reduced and therefore the encapsulation resin 14 can be more easily formed.
(9) In this embodiment, the encapsulation resin 14 is formed of an acrylic resin or an epoxy resin. Therefore, the encapsulation resin 14 can be formed of a low-cost and versatile resin material.

Note that the above embodiment may be modified as follows.

As shown in FIG. 14, a light blocking member 35 having a capability of transmitting visible light and a capability of blocking ultraviolet light may be provided on a surface of the organic EL element 4 on an organic EL display device 70 (i.e., a surface of the second electrode 8 of the organic EL element 4). With such a configuration, in the resin curing step, when the encapsulation resin 14 and the sealing member 5 are formed by irradiation with ultraviolet light through the sealing substrate 20, ultraviolet light entering the organic EL element 4 can be reliably reduced or prevented. As a resuit, a degradation in the organic EL element 4 caused by irradiation with ultraviolet light (i.e., each functional layer included in the organic layer 7 is chemically changed so that the functional layer fails to exhibit its original function) can be reduced or prevented. Also, the light blocking member 35 has a capability of transmitting visible light, and therefore, light emitted from the organic EL element 4 can be extracted through the sealing substrate 20. Therefore, the organic EL display device 1 is applicable to any of the following types: bottom emission type, in which light is extracted through the element substrate 30; top emission type, in which light is extracted through the sealing substrate 20; and double-sided emission type, in which light is extracted through both the element substrate 30 and the sealing substrate 20.

The light blocking member 35 is not particularly limited, and may be, for example, a film made of a material having a capability of absorbing ultraviolet light, a film coated with a coating agent containing an ultraviolet light absorbent, etc. Alternatively, the light blocking member 35 may be provided by forming directly on the surface of the second electrode 8 a coating film made of a coating agent containing an ultraviolet light absorbent. Alternatively, the light blocking member 35 may be provided by forming directly on the surface of the second electrode 8 a vapor deposition film by depositing an ultraviolet light absorbent using vapor deposition etc.

A material for the film having a capability of absorbing ultraviolet light may be, for example, a material including a resin binder and an ultraviolet light absorbent contained in the resin binder. Examples of the ultraviolet light absorbent include inorganic ultraviolet light absorbents, such as ultra small particles made of zinc oxide, titanium oxide, etc., and organic ultraviolet light absorbents, such as benzotriazoles, triazines, benzophenones, etc.

The coating agent containing an ultraviolet light absorbent may be, for example, a mixture of acrylic emulsion or a coating solution containing low molecular-weight thermosetting urethane acrylate and a catalyst etc., and an ultraviolet light absorbent, which is prepared by wet dispersion.

Note that the light blocking member 35 preferably has an ultraviolet light blocking rate of 90% or more, more preferably 95% or more, and even more preferably 98% or more. This is because if the ultraviolet light blocking rate is less than 90%, it is difficult to impart a sufficient ultraviolet light blocking function to the light blocking member 35, so that the function of each functional layer included in the organic layer 7 may be degraded.

The light blocking member 35 may be formed as follows. In the organic EL element formation step, after the second electrode 8 may be formed, a benzotriazole derivative layer may be formed on the second electrode 8 by, for example, vacuum vapor deposition. Note that the vapor deposition rate may be 0.5 Å/s, and the thickness may be adjusted so that the ultraviolet light blocking rate is 95% or more.

### INDUSTRIAL APPLICABILITY

As described above, the present invention is useful for an organic EL display device including an organic EL element, and a method for manufacturing the organic EL display device.

### DESCRIPTION OF REFERENCE CHARACTERS

- 1: ORGANIC EL DISPLAY DEVICE
- 4: ORGANIC EL ELEMENT
- 5: SEALING MEMBER
- 6: FIRST ELECTRODE
- 7: ORGANIC LAYER
- 8: SECOND ELECTRODE
- 14: ENCAPSULATION RESIN
- 15: PROTECTION FILM
- 17: SPACER
- 20: SEALING SUBSTRATE (SECOND SUBSTRATE)
- 30: ELEMENT SUBSTRATE (FIRST SUBSTRATE)
- 35: LIGHT BLOCKING MEMBER
- 70: ORGANIC EL DISPLAY DEVICE
- E: DISTANCE BETWEEN SEALING MEMBER AND ENCAPSULATION RESIN
- T: THICKNESS OF ENCAPSULATION RESIN
- X: PLANE DIRECTION OF ORGANIC EL DISPLAY DEVICE

## Claims

1. An organic EL display device comprising:
a first substrate;
a second substrate facing the first substrate;
an organic EL element formed on the first substrate and provided between the first substrate and the second substrate;
a sealing member provided between the first substrate and the second substrate, and configured to attach the first substrate and the second substrate together to seal the organic EL element; and
an encapsulation resin formed on the second substrate, provided between the first substrate and the second substrate, and configured to cover a surface of the organic EL element,
wherein
the sealing member and the encapsulation resin are separated apart from each other in a plane direction of the organic EL display device.

2. The organic EL display device of claim 1, wherein
a relationship 0.5L + 0.1T ≤ E ≤ 50T is established, where T is a thickness of the encapsulation resin, E is a distance between the sealing member and the encapsulation resin in the plane direction, and L is a width of the sealing member.

3. The organic EL display device of claim 1 or 2, wherein
the thickness of the encapsulation resin is in a range of 1 µm to 100 µm, both inclusive.

4. The organic EL display device of any one of claims 1-3, wherein
the encapsulation resin is formed of an ultraviolet curable resin.

5. The organic EL display device of any one of claims 1-4, wherein
the encapsulation resin is formed of an acrylic resin or an epoxy resin.

6. The organic EL display device of any one of claims 1-5, wherein
a light blocking member having a capability of transmitting visible light and a capability of blocking ultraviolet light is provided on a surface of the organic EL element.

7. A method for manufacturing an organic EL display device, comprising at least:
an organic EL element formation step of forming an organic EL element on a first substrate;
a sealing member formation step of forming a frame-like sealing member on a second substrate;
a resin material application step of applying a resin material for forming an encapsulation resin to an inside of the sealing member formed on the second substrate, where the resin material is separated apart from the sealing member;
a two-substrate structure formation step of attaching the first substrate and the second substrate together with the sealing member being interposed therebetween, in a vacuum atmosphere, and allowing the resin material to uniformly spread inside the sealing member; and
a resin curing step of curing the resin material to form the encapsulation resin on the second substrate, and curing the resin for forming the sealing member, where the sealing member and the encapsulation resin are separated apart from each other in the plane direction of organic EL display device.

8. The method of claim 7, wherein
in the resin curing step, the sealing member and the encapsulation resin are separated apart from each other so that a relationship 0.5L + 0.1T ≤ E ≤ 50T is established, where T is a thickness of the encapsulation resin, E is a distance between the sealing member and the encapsulation resin in the plane direction, and L is a width of the sealing member.

9. The method of claim 7 or 8, wherein
in the resin material application step, the resin material is dropped and injected inside the sealing member.

10. The method of any one of claims 7-9, wherein
in the resin curing step, heating is performed.
